**Europäisches Patentamt**

**European Patent Office**

**Office européen des brevets**

(19)

(11) Veröffentlichungsnummer : **0 363 985 B1**

(12) ## EUROPÄISCHE PATENTSCHRIFT

(45) Veröffentlichungstag der Patentschrift :
**30.12.92 Patentblatt 92/53**

(51) Int. Cl.⁵ : **H03K 5/02, H03K 19/0952**

(21) Anmeldenummer : **89119075.3**

(22) Anmeldetag : **13.10.89**

(54) **Leistungsverstärkerschaltung für integrierte Digitalschaltungen.**

(30) Priorität : **14.10.88 DE 3835119**

(43) Veröffentlichungstag der Anmeldung :
**18.04.90 Patentblatt 90/16**

(45) Bekanntmachung des Hinweises auf die
Patenterteilung :
**30.12.92 Patentblatt 92/53**

(84) Benannte Vertragsstaaten :
**DE FR GB NL**

(56) Entgegenhaltungen :
**GB-A- 2 167 916
IBM TECHNICAL DISCLOSURE BULLETIN,
Band 19, Nr. 3, August 1976, Seiten 922-923;
R.W. KNEPPER: "Enhancement/depletion mo-
defield-effect transistor driver"
PATENT ABSTRACTS OF JAPAN, Band 9, Nr.
216 (E-340)[1939], 3. September 1985; & JP-
A-60 77 516 (NIPPON DENKI K.K.)02-05-1985
PATENT ABSTRACTS OF JAPAN, Band 1, Nr.
138 (E-77), 12. November 1977, page 6582 E 77;
& JP-A-52 74 250 (SANYO DENKI K.K.)22-
06-1977**

(73) Patentinhaber : **SIEMENS
AKTIENGESELLSCHAFT
Wittelsbacherplatz 2
W-8000 München 2 (DE)**

(72) Erfinder : **von Basse, Paul-Werner, Dipl.-Ing.
Margeritenstrasse 50
W-8190 Wolfratshausen (DE)**
Erfinder : **Dortu, Jean-Marc, Dr. rer. nat.
Kurfürstenstrasse 3
W-8000 München 40 (DE)**
Erfinder : **Herlitzek, Andrea
Gaiglstrasse 16
W-8000 München 2 (DE)**
Erfinder : **Kohlert, Dieter, Dipl.-Ing.
Erzgiessereistrasse 44
W-8000 München 2 (DE)**
Erfinder : **Schaper, Ulrich, Dr. rer. nat.
Englschalkinger Strasse 222
W-8000 München 81 (DE)**

## Beschreibung

Vorliegende Erfindung betrifft das Problem, wie kapazitiv hochbelastete Leitungen innerhalb von integrierten GaAs-Schaltungen, wie sie insbesondere bei Speicherbausteinen auftreten, mit Hilfe einer geeigneten Schaltung in möglichst kurzer Zeit umgeladen werden können. Dabei soll gleichzeitig eine Begrenzung des High-Pegels auf einen definierten Wert gewährleistet sein.

Für dieses Problem existieren bereits verschiedene Lösungen, die mit den nachfolgend beschriebenen Nachteilen behaftet sind:

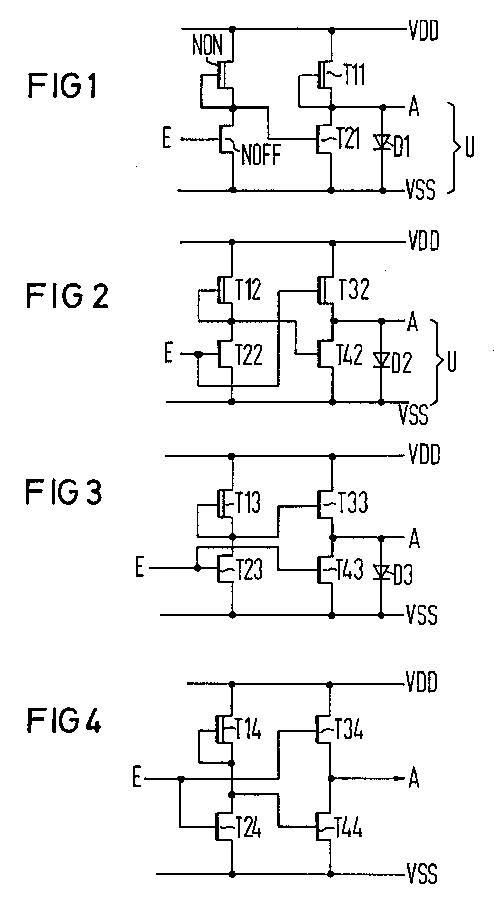

Die Schaltung nach Figur 1 (Yokoyama N., Onodera H., Shinoki T., Ohnishi H., Nishi H.: A 3-ns GaAs 4 kx 1-bit staqtic RAM, IEEE Trans. Electron. Devices, Vol. ED-32 (1985) 9, Seite 1797 bis 1801) stellt nichts anderes als einen Inverter T11, T21 üblicher Art dar, der aufgrund der großen Belastung besonders groß dimensioniert werden muß. Dies bedingt einen hohen Stromverbrauch. Falls eine Begrenzung des High-Pegels nötig ist, muß eine zusätzliche (relativ große) Klemmdiode D1 vorgesehen werden.

Günstiger in bezug auf den Stromverbrauch ist die Schaltung nach Figur 2 (Katano F., Takahashi K., Uetake K., Ueda K., Yamamoto R., Higashisaka A.: Fully decoded GaAs 1 kB statio RAM using closely space electrode FETs, IEEE IEDM, 1983, Seite 336 bis 339; Toyoda N., Kanazawa K., Terada T., Mochizuki M., Ikawa Yasuo, Hojo A.: A 256 x 4 GaAs static RAM, IEEE GaAs Symposium, 1983, Seite 86 bis 89) und Figur 3 (Mead C., Conway L.: Introduction to VLSI systems. Reading: Addison Wesley, Seite 17 bis 18, 1980), da hier während eines Low-Pegels am Ausgang das Gate von T32 bzw. T33 jedenfalls auf Low-Pegel geschaltet wird. Hierdurch wird der Strom durch T32 bzw. T33 beträchtlich vermindert.

Da jedoch T32 und T33 NON-Transistoren (selbstleitend) sind, fließt immer noch ein nicht zu vernachlässigender Querstrom durch T32 und T42 bzw. durch T33 und T43. Zur Begrenzung des High-Pegels muß ebenfalls eine relativ große Klemmdiode D2 bzw. D3 vorgesehen werden, die Platz benötigt und als zusätzliche kapazitive Last wirkt.

Die Schaltung nach Figur 4 (Takano S., Tanino N., Yoshihara T., Mitsui Y., Nishitani K.: A GaAs 1-kbit static RAM with a shallow recessed-gate structure FET, IEEE Trans. Electron Devices, Vol. ED-32 (1985), 6, Seiten 1135 bis 1139) erweist sich in bezug auf den Stromverbrauch am günstigsten. Allerdings erreicht sie am Ausgang nicht den vollen High-Pegel, da der Transistor T34 als Sourcefolger wirkt, dessen Source-Potential immer um mindestens eine Schwellspannung unter dem Gate-Potential liegt. Das Gate-Potential von T34 kann aufgrund der Gate-Source-Diode von T24 den High-Pegel nicht überschreiten.

Aufgabe der vorliegenden Erfindung ist, eine Schaltungsanordnung anzugeben, die ein rasches Umladen ermöglicht und dabei die niedrige Dauerstromaufnahme einer Noff-push-pull-Ausgangsstufe mit dem gut definierten High-Pegel einer NON-NOFF-Verstärkerstufe mit externer Klemmdiode kombiniert.

Diese Aufgabe wird mit einer Schaltung mit den Merkmalen des Anspruches 1 gelöst. Zusätzlich wird gemäß den Merkmalen des Anspruches 2 eine Optimierung der Anstiegsflanke durch schnelle Ansteuerung und transiente, das heißt kurzzeitige, Übersteuerung erreicht. Ein vorgeschalteter Inverter reduziert die Eingangskapazität der gesamten Schaltung.

Es folgt eine Beschreibung anhand der Figuren 5 bis 10.

Figur 5 zeigt das Schaltbild einer erfindungsgemäßen Schaltung.

Figur 6 zeigt das Schaltbild einer nichtbeanspruchten, dem Schaltbild von Figur 5 entsprechenden Schaltung ohne den Begrenzerteil.

Figur 7 zeigt ein vereinfachtes Ersatzschaltbild eines GaAs-MESFET.

Figur 8 zeigt das Schaltverhalten eines DCFL-Inverters.

Figur 9 zeigt das Schaltverhalten einer NOFF-push-pull-Stufe.

Figur 10 zeigt das Schaltbild einer erfindungsgemäßen Verstärkerschaltung mit transienter Übersteuerung.

Zunächst wird die Funktion der Schaltung ohne Berücksichtigung der High-Pegel-Begrenzung beschrieben.

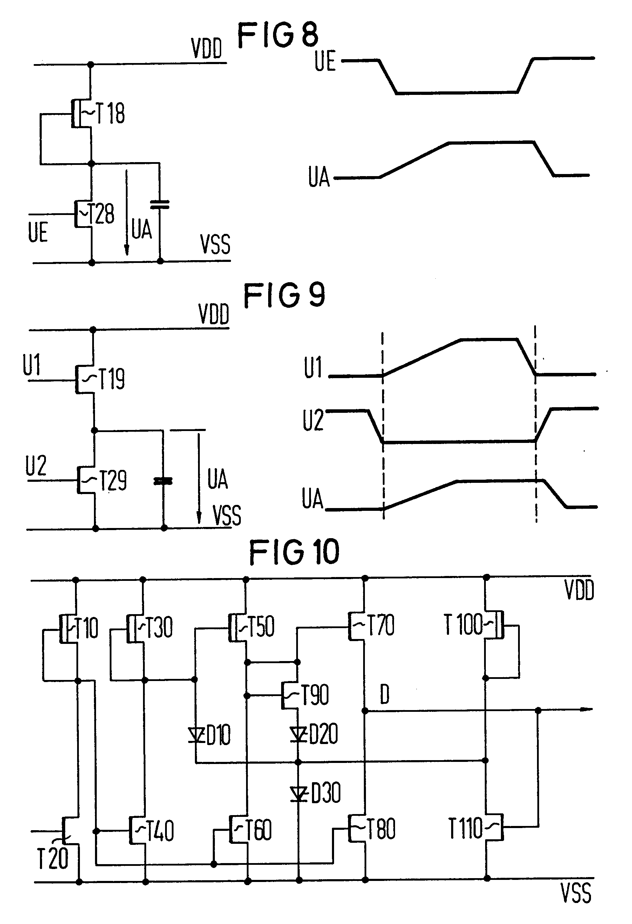

Ein Hauptproblem bei Schaltungen mit ungeschalteten Lastelementen (übliche NMOS-Schaltungstechnik, NON-Lastelemente in GaAs-MESFET-Logik) sind langsame Anstiegsflanken der Ausgangssignale, insbesondere bei hoher kapazitiver Belastung. Da die Lastelemente mit konstanter Gate-Source-Spannung betrieben werden, die Gate-Source-Spannung der Schalttransistoren aber von null auf einen Maximalwert durchgeschaltet wird, werden sich immer flachere Anstiegs- als Abfallflanken ergeben (Figur 8).

Bei der Verwendung einer push-pull-Ausgangsstufe aus NOFF-Transitoren (selbstsperrend) (Figur 9) verstärkt sich diese Problematik noch, da der Pull-up-Ausgangstransistor (T19 in Figur 9) als Sourcefolger geschaltet ist, das heißt die Ausgangsspannung UA (Figur 9) liegt immer um die Gate-Source-Spannung von T19 unter der Spannung U1, so daß der Spannungsanstieg von UA immer langsamer als der von U1 sein wird.

Aus diesem Grunde ist es notwendig, das Gate des Pull-up-Transistors mit einer Schaltung anzusteuern, die eine möglichst hohe Ansteuerspannung mit schneller Anstiegsflanke ermöglicht. Die Schaltung aus T36, T46, T56 und T66 ("Superbuffer"; Mead C., Conway L.: Introduction to VLSI systems,

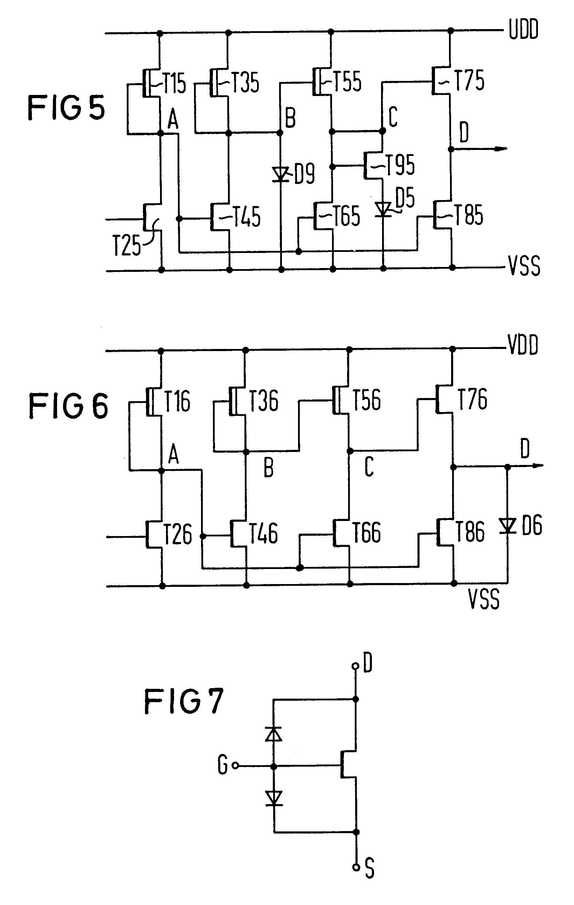

Reading: Addison Wesley, Seite 17 bis 18, 1980) erfüllt diese Forderung (Figur 6).

Die beiden Ausgangstransistoren der Push-pull-
Stufe müssen durch komplementäre Signale ansteuert werden. Die hierzu nötige Inversion wird ebenfalls
durch den Superbuffer T36, T46, T56, T66 bewerkstelligt. Der Inverter T16, T26 dient dazu, die immer
noch relativ große kapazitive Last von der vorhergehenden Stufe abzutrennen. Da sowohl der
Superbuffer T36, T46, T56, T66 wie auch der Pull-
down-Transistor T86 eine ausreichend schnelle Abfallflanke liefern, reicht zu ihrer Aussteuerung der einfache Inverter T16, T26.

Im Gegensatz zu MOS-Transistoren ist das Gate
beim MESFET nicht vom Kanal isoliert, sondern über
eine Schottky-Diode mit ihm verbunden. Daraus resultiert eine Diodenwirkung zwischen dem Gate und
den anderen Anschlüssen, wie sie in Figur 7 dargestellt ist. Die Flußspannung dieser Dioden bestimmt
den logischen High-Pegel in einer Schaltung, da die
Spannung am Eingang eines Gatters (zum Beispiel
Inverter T16, T26 in Figur 6) von dieser Diode begrenzt wird.

In Figur 6 ist zu erkennen, daß für die Punkte B
und C eine solche Begrenzung nicht existiert, da sie
nicht mit Gateeingängen von Transistoren verbunden
sind, deren Sourceanschlüsse auf VSS liegen, und
NON-Transistoren erst bei negativen Gate-Source-
Spannungen sperren. Aus diesem Grunde können
die Spannungen an den Punkten B und C bis zur Versorgungsspannung ansteigen.

Dies hätte zur Folge, daß auch die Ausgangsspannung (Punkt D) eine Spannung weit über dem
festgelegten High-Pegel (Versorgungsspannung größer als Flußspannung einer Gate-Diode) erreichen
kann. Dies kann in einigen Anwendungen (zum Beispiel Wortleitungsansteuerung in Speicherbaustein)
zu Zerstörung der Gates führen.

Eine Begrenzung der Ausgangsspannung durch
eine Klemmdiode D6 (Figur 6) würde bewirken, daß
sich an Transistoren T76 eine sehr hohe Gate-
source-Spannung einstellt und damit ein großer
Strom durch T76 und die Diode D6 fließt. Da es sich
bei T76 in der Regel ohnehin um groß dimensionierte
Transistoren handelt, ergäbe sich ein nicht akzeptabler Dauerstrom. Eine Begrenzung des Gatepotentials
von T76 (Punkt C) erweist sich also als notwendig (Figur 5).

Hierzu dient die Serienschaltung von NOFF-
Transistor T95 und Diode D5, die dazu führt, daß die
Spannung an Punkt C auf die Summe einer Diodenflußspannung und der Gate-source-Spannung von
T95 begrenzt wird.

An der Anode von Diode D5 wird sich die Spannung einstellen, die dem festgelegten High-Pegel entspricht, da die Diode von gleicher Art ist wie die Gate-
source-Diode am Eingang eines Gatters. Zur Kompensation der Gate-source-Spannung von T75 dient Transistors T95. Da die Transistoren T75 und T95
vom gleichen Typ sind, werden sich Gate-source-
Spannungen einstellen, die nur wenig voneinander
abweichen. Dies gilt vor allem dann, wenn die Verhältnisse der Ströme zu den Transistorabmessungen
von T75 und T95 übereinstimmen. Aufgrund der gleichen, aber schwachen Abhängigkeit der Gate-
Spannung vom Drainstrom werden die beiden Gate-
source-Spannungen auch bei beträchtlichen Abweichungen der oben genannten Belastungsverhältnisse noch gut übereinstimmen. Insbesondere
Schwankungen der Schwellspannungen der NOFF-
Transistoren werden auf diese Weise kompensiert.
Am Ausgang (Punkt D) des Verstärkers wird sich also
mit geringer Abhängigkeit vom zu liefernden Strom
als stabiler High-Pegel eine Spannung einstellen, die
dem von der Diode D5 vorgegebenen Pegel entspricht.

Diode D9 hat die Aufgabe, die Gatespannung von
T55 und damit den Strom durch T55, T95 und D5 zu
begrenzen.

Figur 10 zeigt eine Leistungsverstärkerschaltung
mit niedriger Stromaufnahme, definiertem High-
pegel und transienter, das heißt kurzzeitiger Übersteuerung zur Erhöhung der Schaltgeschwindigkeit.

Die Kombination aus Diode D5 und Transistor
T95 in Figur 5 wird nicht schlagartig bei Erreichen einer Schaltschwelle leitend, sondern allmählich, beginnend schon bei niedrigeren Spannungen. Durch
den allmählichen Anstieg des Stromes durch T95 und
D5 wird auch der Spannungsanstieg am Ausgang
(Punkt D) gebremst.

Dies bedeutet eine Verschlechterung der Steilheit der Anstiegsflanke.

Figur 10 zeigt die erfindungsgemäße Lösung,
den Einfluß der Begrenzerschaltung auf die Anstiegsflanke zu beseitigen.

Hier werden die negativen Anschlüsse (Kathoden) der Dioden D10 und D20 nicht statisch auf Masse gehalten, sondern mit Hilfe des Inverters, bestehend aus T100 und T110, gesteuert. Hierdurch wird
erreicht, daß die Pegelbegrenzung erst dann aktiv
wird, wenn der Ausgang des Verstärkers die Schaltschwelle des Inverters T100, T110 überschreitet und
der Inverter die negativen Anschlüsse von D10 und
D20 in die Nähe des Massepotentials bringt. Da dies
erst nach der Laufzeit durch den Inverter der Fall ist,
kann das Gatepotential kurzzeitig über seinen stationären Maximalpegel überschwingen. Dadurch bleibt
die Anstiegsflanke der Ausgangsspannung des Verstärkers bis zum Erreichen ihres Maximalwertes sehr
steil. Diese transiente Übersteuerung läßt sich durch
Einbau zusätzlicher Laufzeiten noch verstärken. Da
es sich bei der hier beschriebenen Anordnung um eine rückgekoppelte Schaltung handelt, ist dafür zu sorgen, daß sich in dem Zustand der Schaltung, in dem
die Begrenzerschaltung aktiv ist, keine Schleifenverstärkung ergibt, um Schwingneigung zu vermeiden.

Dies läßt sich durch eine geeignete Dimensionierung von T110 erreichen.

Die Diode D30 dient dazu, bei hohen Versorgungsspannungen das Überschwingen des Gatepotentials von T70 zu begrenzen.

**Patentansprüche**

1. Digital-Verstärkerschaltung, bei der
    - ein erster FET (T15), ein zweiter FET (T25), einer dritter FET (T35), ein vierter FET (T45), ein fünfter FET (T55), ein sechster FET (T65), ein siebter FET (T75) und ein achter FET (T85) vorhanden sind,
    - der erste FET (T15), der dritte FET (T35) und der fünfte FET (T55) NON-Transistoren (selbstleitend; normally on) sind,
    - der zweite FET (T25), der vierte FET (T45), der sechste FET (T65), der siebte FET (T75) und der achte FET (T85) NOFF-Transistoren; (selbstsperrend; normally off) sind,
    - die Drain-Anschlüsse des ersten FET (T15), des dritten FET (T35), des fünften FET (T55) und des siebten FET (T75) miteinander verbunden sind,
    - die Source-Anschlüsse des zweiten FET (T25), des vierten FET (T45), des sechsten FET (T65) und des achten FET (T85) miteinander verbunden sind,
    - der Source-Anschluß des ersten FET (T15) mit dem Gate-Anschluß des ersten FET (T15), mit dem Drain-Anschluß des zweiten FET (T25), mit dem Gate-Anschluß des vierten FET (T45), mit dem Gate-Anschluß des sechsten FET (T65) und mit dem Gate-Anschluß des achten FET (T85) verbunden ist,
    - der Source-Anschluß des dritten FET (T35) mit dem Gate-Anschluß des dritten FET (T35), mit dem Drain-Anschluß des vierten FET (T45) und mit dem Gate-Anschluß des fünften FET (T55) verbunden ist,
    - der Source-Anschluß des fünften FET (T55) mit dem Drain-Anschluß des sechsten FET (T65) und mit dem Gate-Anschluß des siebten FET (T75) verbunden ist,
    - der Source-Anschluß des siebten FET (T75) mit dem Drain-Anschluß des achten FET (T85) verbunden ist,
    - ein neunter FET (T95) vorhanden ist,
    - der Gate-Anschluß des neunten FET (T95) mit dem Drain-Anschluß des sechsten FET (T65) verbunden ist,
    - der Drain-Anschluß dieses neunten FET (T95) mit dem Gate-Anschluß des siebten FET (T75) verbunden ist,
    - eine erste Diode (D5) und eine zweite Diode (D9) vorhanden sind,
    - der Source-Anschluß des neunten FET (T95) mit dem positiven Anschluß dieser ersten Diode (D5) verbunden ist,
    - der Source-Anschluß des dritten FET (T35) mit dem positiven Anschluß dieser zweiten Diode (D9) verbunden ist und
    - die negativen Anschlüsse der ersten Diode (D5) und der zweiten Diode (D9) mit dem Source-Anschluß des achten FET (T85) verbunden sind.

2. Digital-Verstärkerschaltung nach Anspruch 1, bei der
    - eine dritte Diode (D30), ein zehnter FET (T100) und ein elfter FET (T110) vorhanden sind,
    - die negativen Anschlüsse der ersten Diode (D5) und der zweiten Diode (D9) über diese dritte Diode (D30) mit dem Source-Anschluß des achten FET (T85) verbunden sind und dabei der negative Anschluß dieser dritten Diode (D30) mit dem Source-Anschluß des achten FET (T80) verbunden ist,
    - der Drain-Anschluß des zehnten FET (T100) mit dem Drain-Anschluß des siebten FET (T70) verbunden ist,
    - der Source-Anschluß des zehnten FET (T100) mit dem Gate-Anschluß des zehnten FET (T100), mit dem Drain-Anschluß des elften FET (T110) und mit dem positiven Anschluß der dritten Diode (D30) verbunden ist,
    - der Source-Anschluß des elften FET (T110) mit dem Source-Anschluß des achten FET (T80) verbunden ist und
    - der Gate-Anschluß des elften FET (T110) mit dem Drain-Anschluß des achten FET (T80) verbunden ist.

**Claims**

1. Digital amplifier circuit, in which
    - there are a first FET (T15), a second FET (T25), a third FET (T35), a fourth FET (T45), a fifth FET (T55), a sixth FET (T65), a seventh FET (T75) and an eighth FET (T85),
    - the first FET (T15), the third FET (T35) and the fifth FET (T55) are NON transistors (self-conductive, normally on),
    - the second FET (T25), the fourth FET (T45), the sixth FET (T65), the seventh FET (T75) and the eighth FET (T85) are NOFF transistors (self-blocking, normally off),
    - the drain connections of the first FET (T15), of the third FET (T35), of the fifth FET (T55) and of the seventh FET (T75) are connected to one another,

- the source connections of the second FET (T25), of the fourth FET (T45), of the sixth FET (T65) and of the eighth FET (T85) are connected to one another,
- the source connection of the first FET (T15) is connected to the gate connection of the first FET (T15), to the drain connection of the second FET (T25), to the gate connection of the fourth FET (T45), to the gate connection of the sixth FET (T65) and to the gate connection of the eighth FET (T85),
- the source connection of the third FET (T35) is connected to the gate connection of the third FET (T35), to the drain connection of the fourth FET (T45) and to the gate connection of the fifth FET (T55),
- the source connection of the fifth FET (T55) is connected to the drain connection of the sixth FET (T65) and to the gate connection of the seventh FET (T75),
- the source connection of the seventh FET (T75) is connected to the drain connection of the eighth FET (T85),
- there is a ninth FET (T95),
- the gate connection of the ninth FET (T95) is connected to the gate connection of the sixth FET (T65),
- the drain connection of this ninth FET (T95) is connected to the gate connection of the seventh FET (T75),
- there are a first diode (D5) and a second diode (D9),
- the source connection of the ninth FET (T95) is connected to the positive connection of this first diode (D5),
- the source connection of the third FET (T35) is connected to the positive connection of this second diode (D9) and
- the negative connections of the first diode (D5) and of the second diode (D9) are connected to the source connection of the eighth FET (T85).

2. Digital amplifier circuit according to Claim 1, in which
- there are a third diode (D30), a tenth FET (T100) and an eleventh FET (T100),
- the negative connections of the first diode (D5) and of the second diode (D9) are connected via this third diode (D30) to the source connection of the eighth FET (T85) and, at the same time, the negative connection of this third diode (D30) is connected to the source connection of the eighth FET (T80),
- the drain connection of the tenth FET (T100) is connected to the drain connection of the seventh FET (T70),
- the source connection of the tenth FET (T100) is connected to the gate connection of the tenth FET (T100), to the drain connection of the eleventh FET (T110) and to the positive connection of the third diode (D30),
- the source connection of the eleventh FET (T110) is connected to the source connection of the eighth FET (T80) and
- the gate connection of the eleventh FET (T110) is connected to the drain connection of the eighth FET (T80).

## Revendications

1. Circuit amplificateur numérique, dans lequel
- il est prévu un premier transistor FET (T15), un second transistor FET (T25), un troisième transistor FET (T35), un quatrième transistor FET (T45), un cinquième transistor FET (T55), un sixième transistor FET (T65), un septième transistor FET (T75) et un huitième transistor FET (T85)
- le premier transistor FET (T15), le troisième transistor FET (T35) et le cinquième transistor FET (T55) sont des transistors NON (autoconducteurs; normally on)
- le second transistor FET (T25), le quatrième transistor FET (T45), le sixième transistor FET (T65), le septième transistor FET (T75) et le huitième transistor FET (T85) sont des transistors NOFF (autobloquants; normally off),
- les bornes de drain du premier transistor FET (T15), du troisième transistor FET (T35), du cinquième transistor FET (T55) et du septième transistor FET (T75) sont reliées entre elles,
- les bornes de source du second transistor FET (T25), du quatrième transistor FET (T45), du sixième transistor FET (T65) et du huitième transistor FET (T85) sont reliées entre elles,
- la borne de source du premier transistor FET (T15) est raccordée à la borne de grille du premier transistor FET (T15), à la borne de drain du second transistor FET (T25), à la borne de grille du quatrième transistor FET (T45), à la borne de grille du sixième transistor FET (T65) et à la borne de grille du huitième transistor FET (T85),
- la borne de source du troisième transistor FET (T35) est raccordée à la borne de grille du troisième transistor FET (T35), à la borne de drain du quatrième transistor FET (T45) et à la borne de grille du cinquième transistor FET (T55),
- la borne de source du cinquième transistor FET (T55) est raccordée à la borne de drain du sixième transistor FET (T65) et à la borne de grille du septième transistor FET (T75),

- la borne de source du septième transistor FET (T75) est raccordée à la borne de drain du huitième transistor FET (T85),
- il est prévu un neuvième transistor FET (T95),
- la borne de grille du neuvième transistor FET (T95) est raccordée à la borne de drain du sixième transistor FET (T65),
- la borne de drain de ce neuvième transistor FET (T95) est raccordée à la borne de grille du septième transistor FET (T75),
- il est prévu une première diode (D5) et une seconde diode (D9),
- la borne de source du neuvième transistor FET (T95) est raccordée à la borne positive de la première diode (D5),
- la borne de source du troisième transistor FET (T35) est raccordée à la borne positive de cette seconde diode (D9), et
- les bornes négatives de la première diode (D5) et de la seconde diode (D9) sont raccordées à la borne de source du huitième transistor FET (T85).

2. Circuit amplificateur numérique suivant la revendication 1, dans lequel
- il est prévu une troisième diode (D30), un dixième transistor FET (T100) et un onzième transistor FET (T110),
- les bornes négatives de la première diode (D5) et de la seconde diode (D9 ) sont raccordées, par l'intermédiaire de cette troisième diode (D30), à la borne de source du huitième transistor FET (T85), et la borne négative de cette troisième diode (D30) est raccordée à la borne de source du huitième transistor FET (T80),
- la borne de drain du dixième transistor FET (T100) est raccordée à la borne de drain du septième transistor FET (T70),
- la borne de source du dixième transistor FET (T100) est raccordée à la borne de grille du dixième transistor FET (T100), à la borne de drain du onzième transistor FET (T110) et à la borne positive de la troisième diode (D30),
- la borne de source du onzième transistor FET (T110) est raccordée à la borne de source du huitième transistor FET (T80), et
- la borne de grille du onzième transistor FET (T110) est raccordée à la borne de drain du huitième transistor FET (T80).

FIG 1

FIG 2

FIG 3

FIG 4

FIG 5

FIG 6

FIG 7

# FIG 8

# FIG 9

# FIG 10